(19) Europäisches Patentamt
European Patent Office
Office européen des brevets

(11) **EP 2 599 225 B1**

(12) **FASCICULE DE BREVET EUROPEEN**

(45) Date de publication et mention
de la délivrance du brevet:
**28.08.2019 Bulletin 2019/35**

(21) Numéro de dépôt: **11735665.9**

(22) Date de dépôt: **26.07.2011**

(51) Int Cl.:
***H03L 7/07*** *(2006.01)*     ***H03L 7/22*** *(2006.01)*
***G01S 1/00*** *(2006.01)*

(86) Numéro de dépôt international:
**PCT/EP2011/062821**

(87) Numéro de publication internationale:
**WO 2012/013669 (02.02.2012 Gazette 2012/05)**

(54) **SYSTEME DE REFERENCE DE FREQUENCE NON AFFECTE DE MICRO-SAUTS DE FREQUENCE**

FREQUENZREFERENZSYSTEM OHNE BEEINTRÄCHTIGUNG DURCH FREQUENZ-MIKROSPRÜNGE

FREQUENCY REFERENCE SYSTEM THAT IS NOT ADVERSELY AFFECTED BY FREQUENCY MICRO-HOPS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.07.2010 FR 1003119**

(43) Date de publication de la demande:
**05.06.2013 Bulletin 2013/23**

(73) Titulaire: **Safran Electronics & Defense**
**92100 Boulogne-Billancourt (FR)**

(72) Inventeurs:
• **CHAMINADAS, Francis**
**F-75015 Paris (FR)**
• **LUNEAU, Ghislain**
**F-75015 Paris (FR)**
• **LE LIBOUX, Jean-Christophe**
**F-75015 Paris (FR)**

(74) Mandataire: **Regimbeau**
**20, rue de Chazelles**
**75847 Paris Cedex 17 (FR)**

(56) Documents cités:
**FR-A1- 2 814 870       US-A- 4 625 180**
**US-A1- 2005 157 829**

**Description**

<u>DOMAINE DE L'INVENTION</u>

Le domaine de l'invention est celui des systèmes de fourniture d'une référence de fréquence exploitant la précision des oscillateurs à quartz.

Une application privilégiée, bien que non exclusive de l'invention, concerne la réception des signaux GNSS (« Global Navigation Satellite System »), en particulier les signaux GPS (« Global Positioning System »).

<u>ARRIERE PLAN DE L'INVENTION</u>

Les oscillateurs à quartz sont des composants très largement utilisés dans l'industrie électronique pour servir de référence de fréquence ou de temps.

Ces oscillateurs utilisent un cristal de quartz qui présente des caractéristiques remarquables de résonance, ce qui permet notamment de répondre aux contraintes de stabilité et de pureté spectrale requises par les systèmes de communications modernes. En revanche, le cristal de quartz reste intrinsèquement très sensible à des variations de température impactant ainsi la stabilité de l'oscillateur qui l'utilise, ce qui devient un handicap pour certaines applications.

De nombreuses solutions existent à ce jour pour pallier à ce défaut de stabilité, comme en atteste le tableau suivant.

| Solution | Avantages | Inconvénients |
|---|---|---|
| | | |
| TCXO (« Temperature-Compensated Crystal Oscillator ») Oscillateur compensé en température | Bonne stabilité en Température Faible consommation | Présence de micro-sauts de fréquence |
| MCXO (« Microcontroler-Compensated Crystal Oscillator ») DCXO (« Digitally-Controled Crystal Oscillator ») Oscillateur compensé en température numériquement | Bonne stabilité en Température Consommation modérée | Présence de micro-sauts de fréquence et de sauts de phase Mise en oeuvre complexe |
| OCXO (« Oven-Controled Crystal Oscillator ») Oscillateur dans une enceinte thermostatée | Très bonne stabilité en température Faible risque de micro-sauts de fréquence | Temps de chauffe Consommation élevée |

On notera que toutes ces solutions à base de quartz sont sujettes à des micro-sauts de fréquence. Par ailleurs, contrairement aux variations de fréquence dues à la température, les variations dues aux micro-sauts sont très rapides (typiquement inférieures à la milliseconde).

Bien que le quartz de l'oscillateur OCXO soit maintenu à température constante, cet oscillateur n'est cependant pas exempt de micro-sauts de fréquence, même si leur apparition est très sensiblement réduite.

Les micro-sauts de fréquence, qui apparaissent de manière totalement aléatoire dans la vie de l'oscillateur (imprévisibilité de l'instant d'apparition et de l'amplitude du saut), ne peuvent pas être facilement pris en compte ou compensés.

Les phénomènes à l'origine des ces micro-sauts n'étant pas tous identifiés, les fabricants d'oscillateurs à quartz ne peuvent pas garantir, malgré des procédures onéreuses de tri, l'absence de micro-saut.

Or l'apparition de micro-sauts de fréquence s'avère notamment problématique dans des applications dans lesquelles la continuité de phase et de fréquence est requise. C'est le cas des applications GNSS à haute précision ou dans des environnements d'interférence élevée (intérieur d'un bâtiment par exemple).

Les systèmes GNSS, dont fait partie le GPS, sont des systèmes de localisation d'équipements à partir de mesures de signaux radioélectriques reçus d'une constellation de satellites. La localisation de l'équipement est obtenue par une triangulation basée sur les mesures des temps d'arrivée des signaux émis par les satellites. La mesure du temps d'arrivée se fait en recherchant puis en asservissant les codes et phases de porteuses du récepteur sur ceux des signaux satellites reçus.

Si les boucles d'asservissement sont larges en période d'acquisition des signaux reçus, elles sont en général de faible bande passante lors de la période de poursuite afin de gagner en rapport signal à bruit ou encore d'améliorer leurs robustesses vis à vis d'interférences externes.

Lorsqu'un micro-saut de fréquence survient sur le quartz de l'oscillateur de référence du récepteur, il introduit des erreurs dans la boucle de poursuite, pouvant aller jusqu'à perdre le signal si ce saut est trop important. Un saut de seulement quelques parties par milliard (ppb) peut effectivement suffire à perdre le signal.

A ce jour, seul un tri des oscillateurs à quartz par observation de leurs micro-sauts de fréquence permet de limiter les impacts du problème. Outre que ce tri est fastidieux et onéreux, il demeure imparfait et ne permet donc pas de garantir l'absence de micro-sauts de fréquence d'un oscillateur à quartz.

On connaît notamment des publications US 4 625 180 A, FR 2 814 870 A1 et US 2005/157829 A1 des synthétiseurs de fréquence qui utilisent une boucle dite PLL qui réalise un asservissement de phase pour piloter un oscillateur auxiliaire du type commandé en tension (VCO : « Voltage Controlled Oscillator ») à partir d'une fréquence de référence de grande stabilité. Ces synthétiseurs sont sensibles aux micro-sauts de fréquence pouvant affecter l'oscillateur à quartz qui fournit la fréquence de référence.

## EXPOSÉ DE L'INVENTION

L'invention a pour objectif de proposer un système de fourniture d'une référence de fréquence qui présente la précision d'un oscillateur à quartz, mais dont la fréquence de sortie n'est pas affectée du phénomène de micro-sauts de fréquence ou est à tout le moins associée à une détection de l'apparition d'un micro-saut.

A cet effet, l'invention propose selon un premier aspect un système de fourniture d'une référence de fréquence, selon la revendication 1.

Le système peut comprendre en outre un multiplicateur interposé entre l'oscillateur primaire et la boucle de rétroaction pour multiplier la référence de fréquence d'un rapport N, et un diviseur agencé en sortie du système pour diviser d'un même rapport N la sortie prise sur l'oscillateur auxiliaire.

## BREVE DESCRIPTION DES DESSINS

D'autres aspects, buts et avantages de la présente invention apparaîtront mieux à la lecture de la description détaillée suivante de formes de réalisation préférées de celle-ci, donnée à titre d'exemple non limitatif, et faite en référence aux dessins annexés sur lesquels:

- la figure 1 représente un système de fourniture d'une référence de fréquence;
- la figure 2 illustre la détection de l'apparition d'un micro-saut de fréquence ;
- la figure 3 représente un mode de réalisation possible du système de fourniture d'une référence de fréquence selon l'invention ;
- les figures 4a-4c représentent la détection de l'apparition d'un micro-saut de fréquence mise en oeuvre dans le système de la figure 3 ;
- les figures 5 et 6 représentent d'autres systèmes de fourniture d'une référence de fréquence mettant en oeuvre une détermination de l'amplitude d'un micro-saut de fréquence et une compensation du micro-saut par rétroaction ;
- la figure 7 illustre la compensation d'un micro-saut de fréquence mise en oeuvre dans le système de la figure 6 ;
- la figure 8 représente un mode de réalisation exploitant deux voies en quadrature pour déterminer l'amplitude d'un micro-saut de fréquence ;
- la figure 9 représente un mode de réalisation permettant d'augmenter la sensibilité de la détection d'un micro-saut de fréquence ou de diminuer le temps nécessaire à la détection ;
- la figure 10 illustre la détermination de l'amplitude d'un micro-saut de fréquence par exploitation de deux voies en quadrature.

## DESCRIPTION DETAILLEE DE L'INVENTION

L'invention concerne un système de fourniture d'une référence de fréquence comprenant un oscillateur à quartz (dit oscillateur primaire), notamment un oscillateur à quartz compensé en température de type TCXO, MCXO, DCXO ou OCXO.

L'invention repose sur l'utilisation d'un oscillateur auxiliaire que l'on vient asservir sur l'oscillateur primaire à quartz afin de donner à l'oscillateur auxiliaire la stabilité en fréquence de l'oscillateur primaire à quartz.

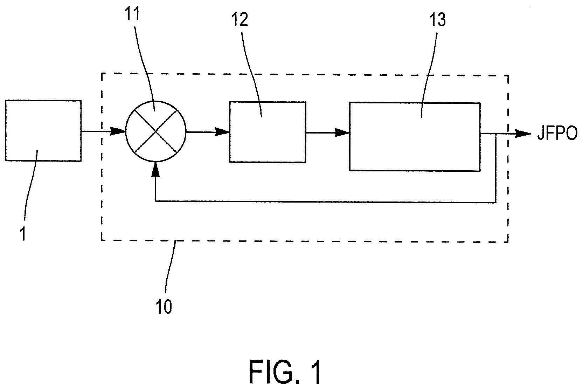

Sur la figure 1, l'oscillateur auxiliaire est, à la différence des oscillateurs auxiliaires de type VCO classiquement utilisés par exemple dans US 4 625 180 A, FR 2 814 870 A1 et US 2005/157829 A1, un oscillateur exempt de micro-sauts de fréquence, utilisant une technologie de résonateur alternative à celle du résonateur à quartz. La sortie prise sur l'oscillateur auxiliaire est ainsi exempte de micro-sauts de fréquence tout en présentant, du fait de l'asservissement, la stabilité en fréquence de l'oscillateur à quartz.

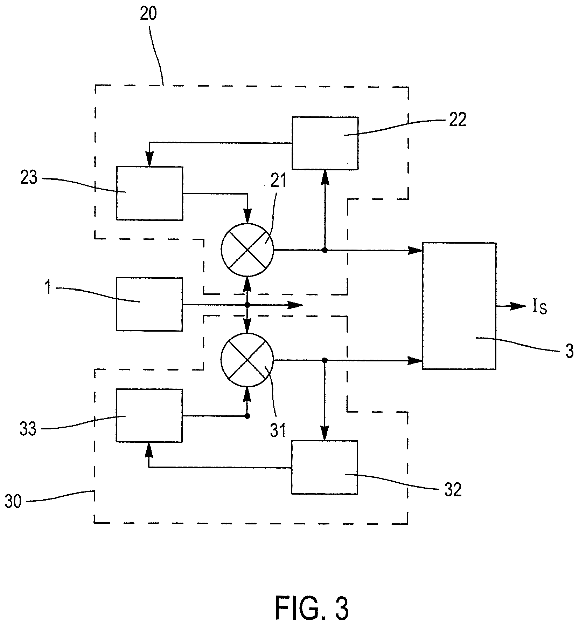

Selon un mode de réalisation de l'invention, représenté par la figure 3, on exploite deux oscillateurs auxiliaires que l'on vient asservir sur l'oscillateur à quartz afin de détecter l'apparition d'un micro-saut de fréquence de l'oscillateur à quartz. La sortie prise sur l'oscillateur à quartz peut ainsi être associée à une information d'apparition d'un micro-saut.

En référence à la figure 1, on a représenté un système de fourniture d'une référence de fréquence comprenant un oscillateur primaire à quartz 1 fournissant une référence de fréquence et une boucle de rétroaction 10 qui comporte un oscillateur auxiliaire non sujet à des micro-sauts de fréquence 13. La référence de fréquence de l'oscillateur à quartz 1 est délivrée à la boucle de rétroaction 10 pour asservir l'oscillateur auxiliaire 13 sur la référence de fréquence de l'oscillateur primaire à quartz. La sortie JFPO du système est prise sur l'oscillateur auxiliaire 13 asservi sur la référence de fréquence de l'oscillateur primaire.

Les oscillateurs sans micro-saut utilisant une technologie de résonateur alternative au résonateur à quartz présentent des performances insuffisantes en terme de précision et de stabilité en température, et ne peuvent donc être utilisés seuls.

Dans le cadre de l'invention, et comme déjà indiqué précédemment, l'asservissement de l'oscillateur secondaire sur l'oscillateur à quartz permet, sur le long terme, de donner à l'oscillateur auxiliaire la stabilité en fréquence de l'oscillateur à quartz.

La sortie JFPO prise sur l'oscillateur auxiliaire est ainsi exempte de micro-sauts de fréquence tout en bénéficiant de la grande précision de l'oscillateur à quartz.

L'asservissement permet plus précisément de gommer la discontinuité liée à l'apparition d'un micro-saut de fréquence tout en conservant la stabilité de l'oscillateur à quartz.

L'oscillateur à quartz est de préférence un oscillateur à quartz compensé en température, par exemple un oscillateur TCXO.

L'oscillateur auxiliaire peut notamment être l'un des oscillateurs listés dans le tableau ci-après qui en indique les principales caractéristiques. Compte tenu de ses avantages, on utilise de préférence un oscillateur à MEMs.

| Solution | Avantages | Inconvénients |
|---|---|---|
| | | |
| Oscillateur à MEMs (« Micro-Electro-Mechanical Systems ») Par exemple oscillateur TCMO (« Temperature-Compensated MEMs Oscillator ») | Non sujet à de micro-sauts de fréquence Très faible sensibilité à l'accélération Grande pureté spectrale Économique | Mauvaise stabilité en Température |
| Oscillateur CMOS (« Complementary Métal Oxide Semiconductor ») | Non sujet à de micro-sauts de fréquence Économique | Mauvaise stabilité en Température Médiocre pureté spectrale |
| Oscillateur à onde acoustique de surface (oscillateur SAW : « Surface Acoustic Wave ») | Non sujet à de micro-sauts de fréquence Sensibilité à l'accélération Grande pureté spectrale | Mauvaise stabilité en Température Prix élevé |

Revenant à la description de la figure 1, la boucle de rétroaction 10 peut être une boucle à verrouillage de phase comprenant un comparateur de phase 11 configuré pour fournir une tension d'erreur de phase dépendant de l'écart de phase entre la référence de fréquence de l'oscillateur primaire 1 et la sortie JFPO prise sur l'oscillateur auxiliaire 13, ainsi qu'un filtre de boucle 12 configuré pour intégrer la tension d'erreur de phase et fournir la commande d'asservissement en fréquence de l'oscillateur auxiliaire 13.

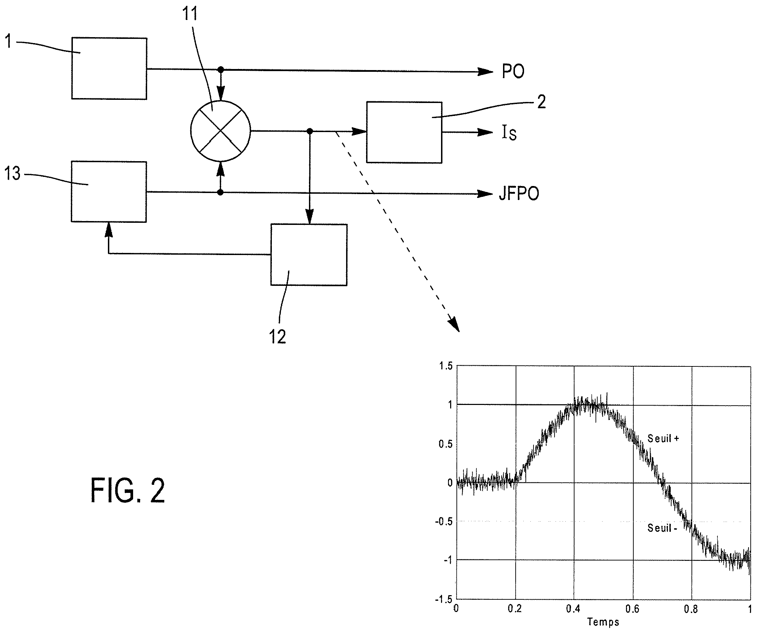

Certaines applications, qui requièrent une référence à quartz, peuvent s'accommoder des micro-sauts à condition que ces micro-sauts soient détectés. La figure 2 représente un système de fourniture d'une référence de fréquence similaire à celui de la figure 1, mais comportant en outre une unité de détection de micro-sauts de fréquence 2 de la référence de fréquence fournie par l'oscillateur primaire à quartz 1. Cette unité 2 est agencée pour recevoir la tension d'erreur de phase en sortie du comparateur de phase 11 et configurée pour indiquer une occurrence d'un micro-saut de fréquence par comparaison de la tension d'erreur de phase à un seuil.

Le système de la figure 2 délivre ainsi les sorties suivantes : une sortie PO prise sur l'oscillateur à quartz 1 sujette aux micro-sauts, une sortie I$_S$ indiquant l'apparition d'un micro-saut de fréquence dans la sortie PO de l'oscillateur à quartz, et la sortie JFPO prise sur l'oscillateur secondaire 13 et exempte de micro-sauts.

On a représenté en bas à droite de la figure 2 l'évolution de la sortie du comparateur de phase 11 en fonction du temps, en cas d'apparition d'un micro-saut à t=0,2 s. Cette sortie est comparée à deux seuils (Seuil+ et Seuil-), le dépassement de l'un des seuils indiquant l'apparition d'un micro-saut.

Comme l'amplitude du signal en sortie du comparateur de phase 11 ne dépend que de son gain, on peut théoriquement détecter des sauts de n'importe quelle amplitude. En réalité, plus le saut est de faible amplitude, plus il faudra du temps pour le détecter. Ainsi la capacité de détection des micro-sauts est directement liée à la valeur minimale permise pour le temps de détection.

On a représenté sur la figure 3, un système de fourniture d'une référence de fréquence conforme à l'invention dont la fréquence de sortie peut rester affectée du phénomène de micro-sauts de fréquence mais est associée à une détection de l'apparition d'un micro-saut.

Sur la figure 3, le schéma de la figure 1 est dupliqué ; le système comprend ainsi deux boucles de rétroaction 20, 30 comprenant chacune un comparateur de phase 21, 31 et un oscillateur auxiliaire 23, 33, la référence de fréquence de l'oscillateur à quartz 1 étant délivrée à chaque boucle de rétroaction 20, 30 pour asservir l'oscillateur auxiliaire 23, 33 de chacune des boucles sur la référence de fréquence de l'oscillateur primaire.

Le système de la figure 3 comprend en outre une unité de détection de micro-sauts de fréquence 3 de la référence de fréquence fournie par l'oscillateur primaire à quartz. Cette unité 3 est agencée pour recevoir la tension d'erreur de phase en sortie de chacun des comparateurs de phase 21, 31 et configurée pour indiquer l'apparition d'un micro-saut de fréquence.

L'unité de détection de saut de fréquence 3 peut notamment être configurée pour mettre en oeuvre une comparaison de la tension d'erreur de phase en sortie de chacun des comparateurs de phase 21, 31 à un seuil, et pour indiquer via sa sortie I$_S$ l'apparition d'un saut de fréquence en cas de double détection de dépassement du seuil. Comme la probabilité d'apparition simultanée d'un micro-saut sur deux oscillateurs est très faible (si ceux-ci sont sujets aux micro-sauts), seule la double détection traduit un saut de fréquence de l'oscillateur primaire TCXO.

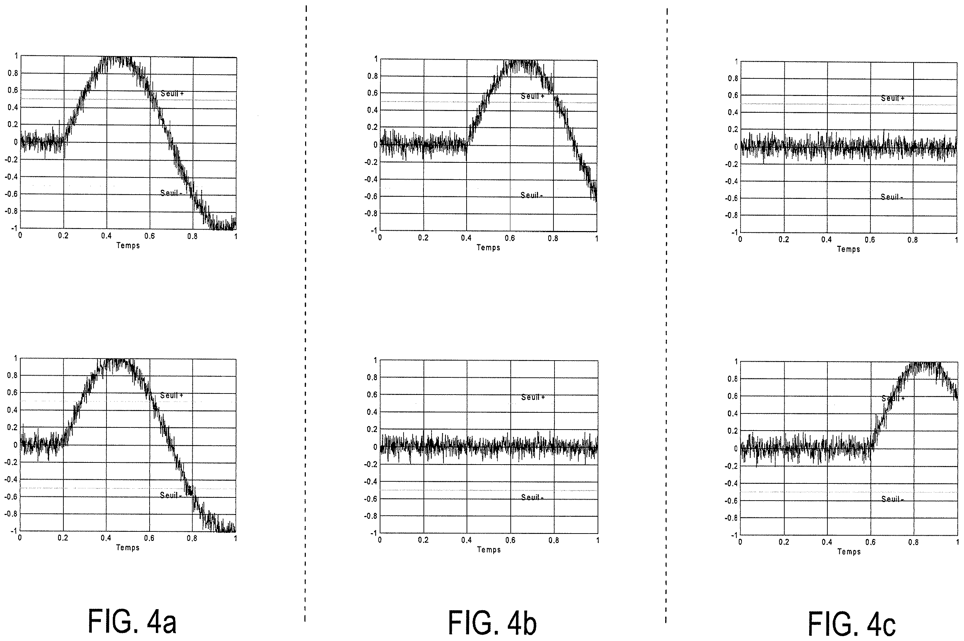

Cette double détection est illustrée par les figures 4a-4c qui représentent en haut la sortie du comparateur de phase 21 et en bas la sortie du comparateur de phase 31 en cas respectivement d'apparition d'un micro-saut de fréquence de l'oscillateur à quartz 1 (figure 4a), de l'oscillateur auxiliaire 23 (figure 4b) et de l'oscillateur auxiliaire 33 (figure 4c). On constate effectivement de ces figures que seule l'apparition d'un micro-saut de l'oscillateur à quartz entraîne un dépassement de seuil de la sortie de chacun des comparateurs de phase 21,31 (l'apparition d'un micro-saut d'un oscillateur auxiliaire n'entraîne effectivement un dépassement de seuil que de l'une seulement des sorties des comparateurs de phase).

L'unité de détection de saut de fréquence 3 peut, à titre d'alternative à la double détection, être configuré pour réaliser une corrélation entre les signaux délivrés par les deux comparateurs de phase 21, 31 et pour comparer le résultat de cette corrélation à un seuil. Le résultat de cette comparaison constitue l'indicateur de saut.

On a vu précédemment que les oscillateurs auxiliaires peuvent être des oscillateurs sujets à des micro-sauts de fréquence, par exemple des oscillateurs TCXO.

L'un et/ou l'autre des oscillateurs auxiliaires peuvent cependant ne pas être sujet à des micro-sauts de fréquence, auquel cas on peut avantageusement exploiter la sortie d'un oscillateur auxiliaire non sujet à des micro-sauts et asservi sur l'oscillateur à quartz. On comprendra que l'on peut ainsi incorporer ces deux boucles de rétroaction à l'architecture de la figure 2 pour fournir une indication d'apparition d'un saut de fréquence de l'oscillateur à quartz (l'unité de détection de micro-sauts 2 de la figure 2 étant alors modifiée pour mettre en oeuvre la double détection ou la corrélation mentionnées ci-dessus).

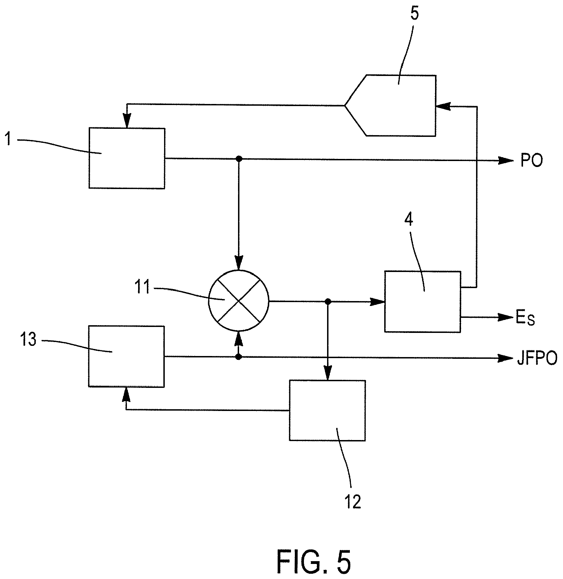

En référence à la figure 5, on a représenté un système dans lequel les micro-sauts de fréquence de l'oscillateur à quartz sont détectés, quantifiés et compensés par rétroaction. Ce mode de réalisation est avantageux pour des applications qui n'acceptent pas de micro-sauts de fréquence mais imposent l'utilisation de la sortie PO de l'oscillateur à quartz, par exemple pour répondre à des contraintes de stabilité à court terme.

Dans le système de la figure 5, l'oscillateur à quartz 1 est un oscillateur commandé en tension. Le système comprend une unité 4 d'estimation de l'amplitude de micro-sauts de fréquence de l'oscillateur à quartz 1 agencée pour recevoir la tension d'erreur de phase en sortie du comparateur de phase 11 et configurée pour fournir une commande de fréquence à l'oscillateur à quartz visant à annuler le micro-saut de fréquence.

L'unité 4 d'estimation de l'amplitude de micro-sauts de fréquence de l'oscillateur à quartz fournit une sortie E$_S$ indiquant l'amplitude d'un micro-saut et reboucle à l'oscillateur à quartz 1, par l'intermédiaire d'un convertisseur numérique analogique 4, une commande de fréquence dont la valeur est incrémentée/décrémentée, chaque fois qu'un micro-saut est détecté, dans le sens contraire de l'amplitude estimée du micro-saut.

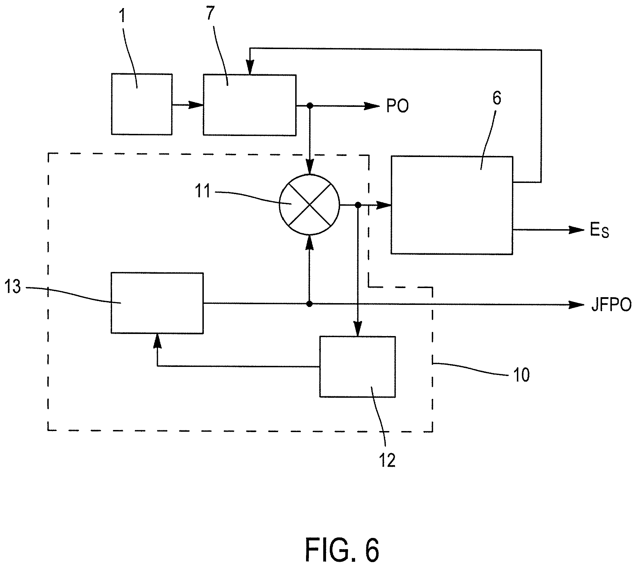

En référence à la figure 6, on a représenté un système dans lequel les micro-sauts de fréquence de l'oscillateur à quartz sont détectés, quantifiés et compensés progressivement par rétroaction.

Ce système s'avère avantageux pour des applications qui peuvent accepter une variation de la fréquence de référence à condition que cette variation soit progressive et à vitesse limitée. Ce système présente en outre l'avantage de ne pas nécessiter d'oscillateur à quartz commandé en tension dont la pureté spectrale peut être dégradée par la présence de signaux parasites sur son entrée de commande de fréquence.

Dans le système de la figure 6, le système comprend un modulateur de phase 7 intercalé entre l'oscillateur à quartz 1 et la boucle de rétroaction 10, ainsi qu'une unité 6 d'estimation de l'amplitude de micro-sauts de fréquence de l'oscillateur à quartz agencée pour recevoir la tension d'erreur de phase en sortie du comparateur de phase 11 et configurée pour fournir une commande de modulation au modulateur de phase.

On propose ainsi après détection et estimation de l'amplitude d'un micro-saut de venir le compenser temporairement, puis de réduire progressivement cette compensation. A la fin de la phase de compensation, le saut retrouve sa valeur initiale, mais la vitesse de son évolution aura été imposée par le taux de réduction de cette compensation.

On utilise de manière préférentielle un modulateur de phase linéaire qui a la propriété de décaler la fréquence du signal qui le traverse d'une valeur qui dépend de la fréquence de modulation. Ainsi dans la phase de compensation, la période de la modulation est fixée initialement à la valeur estimée du saut, puis celle-ci décroît progressivement jusqu'à zéro selon le profil de vitesse adéquat.

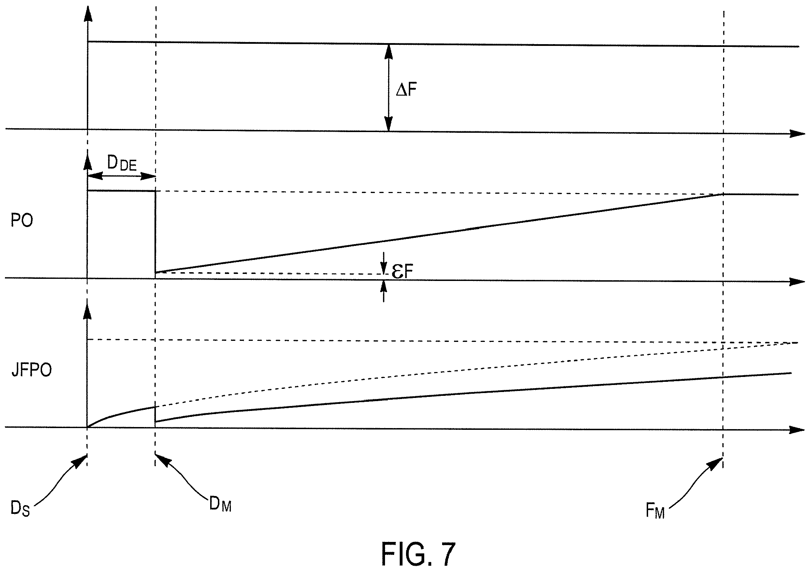

On a représenté de haut en bas sur la figure 7 l'évolution au cours du temps de la fréquence de l'oscillateur à quartz en l'absence de compensation d'un saut de fréquence d'amplitude $\Delta F$, de la fréquence de l'oscillateur à quartz compensé (sortie PO de la figure 6), de la fréquence de l'oscillateur auxiliaire asservi sur l'oscillateur à quartz (sortie JFPO de la figure 6), en cas de mise en oeuvre d'une modulation linéaire.

Le saut de fréquence d'amplitude $\Delta F$ intervient au temps $D_S$ Le saut est détecté et son amplitude estimé après une durée $D_{DE}$. La modulation linéaire débute alors (temps $D_M$), Le saut de fréquence (dont l'amplitude est estimée avec une erreur d'estimation $\varepsilon F$) est alors compensée (période de modulation fixée à la valeur estimée du saut).

Au cours de la phase de modulation qui s'étend jusqu'au temps $F_M$, la période de modulation décroit progressivement vers zéro, de sorte que la fréquence de l'oscillateur à quartz compensé va progressivement retrouver sa valeur initiale.

S'agissant de la sortie JFPO, on a représenté en traits pleins son évolution en cas de mise en oeuvre de la modulation linéaire, et en traits pointillés son évolution en l'absence de mise en oeuvre de la modulation linéaire.

La description qui suit concerne la détermination de l'amplitude $\Delta f$ d'un micro-saut de fréquence de l'oscillateur primaire à quartz, telle qu'elle peut être mise en oeuvre dans les systèmes exposés en liaison avec les figures 5 et 6. On doit pour ce faire déterminer la fréquence du battement en sortie du comparateur de phase.

Une première méthode consiste à réaliser une transformée de Fourier, en particulier une transformée de Fourier rapide, du signal en sortie du comparateur de phase. Cette méthode a cependant pour inconvénient de nécessiter un temps de calcul au moins égal au temps requis pour mémoriser le nombre d'échantillons conduisant à la résolution requise. Par exemple pour une résolution de 1 Hz, le temps de calcul est forcément supérieur à 1 s.

Une seconde méthode consiste à prendre deux échantillons successifs du signal en sortie du comparateur de phase et à déterminer par calcul la fréquence du battement. Bien entendu, la fréquence d'échantillonnage doit être cohérente de la valeur maximale du micro-saut.

Si on suppose que le battement est de type sinusoïdal et que son amplitude crête (Ac) est connu, on a alors: $A(t) = Ac.\sin(2.\pi.\Delta f.t + \varphi)$.

On déduit si on normalise arbitrairement Ac à 1 :

$$2.\pi.\Delta f.t + \varphi + 2.k.\pi = \arcsin [A(t)]$$

ou

$$\pi - 2.\pi.\Delta f.t - \varphi + 2.k.\pi = \arcsin [A(t)]$$

Comme on utilise une période d'échantillonnage inférieure à la période minimale du battement on peut prendre k=0, d'où :

$$2.\pi.\Delta f.t + \varphi = \arcsin [A(t)]$$

ou

$$\pi - 2.\pi.\Delta f.t - \varphi = \arcsin [A(t)]$$

Pour déterminer Δf, on doit faire au moins 2 mesures séparées de Δt (Δf et φ sont inconnues). On a alors :

$$2.\pi.\Delta f.t0 + \varphi = \arcsin (A0)$$

ou

$$\pi - 2.\pi.\Delta f.t0 - \varphi = \arcsin (A0)$$

et

$$2.\pi.\Delta f.(t0+ \Delta t) + \varphi = \arcsin(A1)$$

ou

$$\pi - 2.\pi.\Delta f.(t0+ \Delta t) - \varphi = \arcsin(A1)$$

L'ambiguïté donnée par la fonction arcsin traduit en fait la possibilité d'avoir deux échantillons consécutifs de part et d'autre d'un extremum de la fonction sinus.

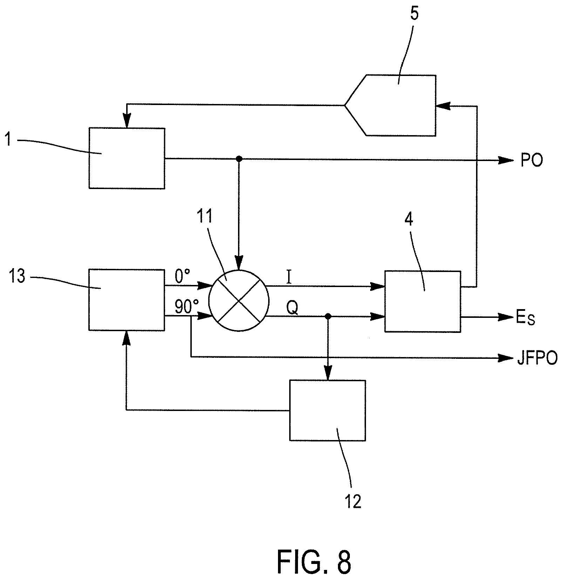

On peut détecter cette situation en exploitation les voies en quadrature I et Q du comparateur de phase comme représenté sur la figure 8, et se ramener au cas nominal.

On déduit alors en retranchant les deux équations ci-dessus :

$$\Delta f = [\arcsin (A1) - \arcsin (A0)] / (2.\pi.\Delta t)$$

Les calculs de cette méthode peuvent se simplifier si on utilise un comparateur de phase linéaire. Dans ce cas le battement est de type triangulaire et l'équation précédente se simplifie selon : Δf = [A1 - A0] / (4.Δt)

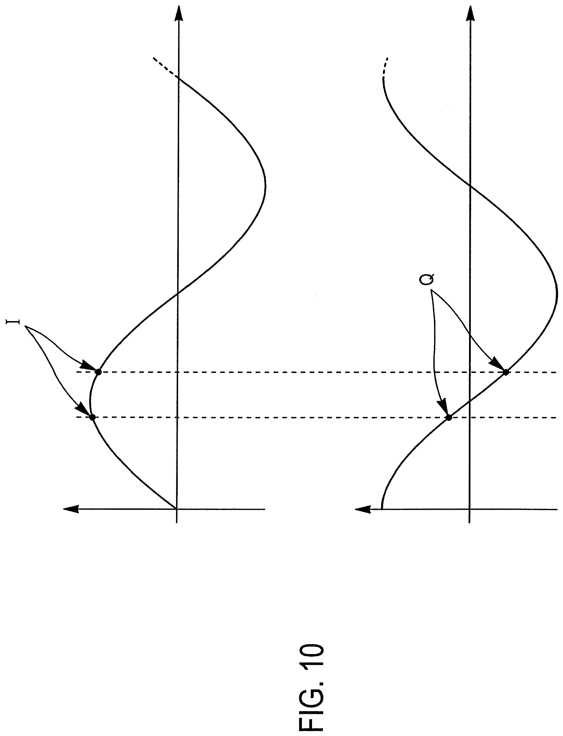

On a représenté sur la figure 10 les voies en quadrature I et Q du comparateur de phase. Dans cet exemple, les échantillons successifs I sur la voie I ne sont pas retenus dans le calcul (car de part et d'autre d'un extremum de la fonction sinus), alors que les échantillons successifs Q de la voie Q sont quant à eux retenus.

On relèvera qu'un oscillateur TCXO peut présenter des micro-sauts de 50 ppb. Dans la mesure où les fabricants ne garantissent pas de valeurs maximales, on fait l'hypothèse qu'il est très peu probable que les micro-sauts dépassent 10 fois cette valeur (soit 500 ppb). Avec cette hypothèse, pour une fréquence de référence de 20 MHz, la fréquence du battement ne dépassera pas 10 Hz. La fréquence d'échantillonnage devra être supérieure à 100 Hz. En réalité, cette valeur peut ne pas être suffisante car elle conduit à un temps de calcul et donc à un temps de recalage d'au moins 20 ms. Si le temps requis est 10 fois plus faible (2 ms), la fréquence d'échantillonnage doit être de 1 kHz.

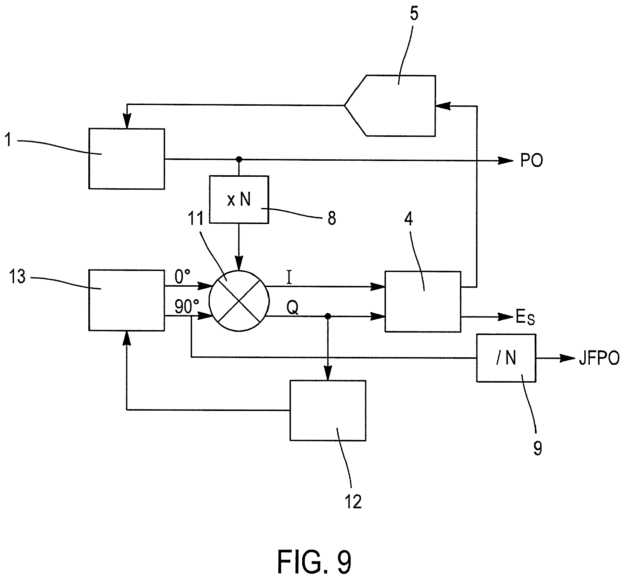

On a représenté sur la figure 9 une variante avantageuse dans laquelle la fréquence de l'oscillateur primaire est multipliée d'un rapport N à l'aide d'un multiplicateur 8 interposé entre l'oscillateur primaire 1 et la boucle de rétroaction, afin d'augmenter la sensibilité de détection ou de diminuer le temps nécessaire à la détection. Un diviseur 9 est par ailleurs agencé en sortie du système pour diviser d'un même rapport N la sortie JFPO prise sur l'oscillateur auxiliaire.

**Revendications**

**1.** Système de fourniture d'une référence de fréquence, comprenant un oscillateur primaire (1) fournissant une référence de fréquence, et comprenant :

- deux boucles de rétroaction (20, 30) comprenant chacune un comparateur de phase (21, 31) et un oscillateur auxiliaire (23, 33), la référence de fréquence étant délivrée à chaque boucle de rétroaction pour asservir l'oscillateur auxiliaire de chacune des boucles sur la référence de fréquence de l'oscillateur primaire ;
- une unité de détection de micro-sauts de fréquence (3) de la référence de fréquence fournie par l'oscillateur primaire à quartz agencée pour recevoir la tension d'erreur de phase en sortie de chacun des comparateurs de phase (21, 31) et configurée pour indiquer une occurrence d'un micro-saut de fréquence, **caractérisé en ce que** l'unité de détection de saut de fréquence (3) est configurée pour mettre en oeuvre

- une comparaison de la tension d'erreur de phase en sortie de chacun des comparateurs de phase à un seuil, et pour indiquer une occurrence d'un saut de fréquence en cas d'apparition simultanée d'un dépassement du seuil sur les deux boucles, ou
- une corrélation entre les erreurs de phase en sortie de chacun des comparateurs de phase, et pour comparer ladite corrélation à un seuil,
et **en ce que** l'oscillateur primaire est à quartz.

2. Système selon la revendication 1, comprenant en outre un multiplicateur (8) interposé entre l'oscillateur primaire (1) et la boucle de rétroaction pour multiplier la référence de fréquence d'un rapport N, et un diviseur (9) agencé en sortie du système pour diviser d'un même rapport N la sortie (JFPO) prise sur l'oscillateur auxiliaire.


**Patentansprüche**

1. System zum Bereitstellen einer Frequenzreferenz, umfassend einen Primäroszillator (1), der eine Frequenzreferenz bereitstellt, und Folgendes umfassend:

- zwei Rückkopplungsschleifen (20, 30), jede einen Phasenvergleicher (21, 31) und einen Hilfsoszillator (23, 33) umfassend, wobei die Frequenzreferenz jeder Rückkopplungsschleife erteilt wird, um den Hilfsoszillator jeder der Schleifen auf der Frequenzreferenz des Primäroszillators anzusteuern;
- eine Einheit zum Detektieren von Frequenz-Mikrosprüngen (3) der durch den Quarz-Primäroszillator bereitgestellten Frequenzreferenz, angeordnet, um die Phasenfehlerspannung am Ausgang jedes der Phasenvergleicher (21, 31) zu empfangen und konfiguriert, um auf ein Auftreten eines Frequenz-Mikrosprungs hinzuweisen,
**dadurch gekennzeichnet, dass** die Einheit zum Detektieren von Frequenz-Mikrosprüngen (3) konfiguriert ist, um Folgendes durchzuführen
- einen Vergleich der Phasenfehlerspannung am Ausgang jedes der Phasenvergleicher mit einem Schwellenwert, und um auf ein Auftreten eines Frequenzsprunges im Falle eines gleichzeitigen Erscheinens einer Schwellenwertüberschreitung an den beiden Schleifen hinzuweisen, oder
- eine Korrelation zwischen den Phasenfehlern am Ausgang jedes der Phasenvergleicher, und um die Korrelation mit einem Schwellenwert zu vergleichen,
und dadurch, dass der Primäroszillator mit Quarz ist.

2. System nach Anspruch 1, weiter einen Multiplikator (8) umfassend, der zwischen dem Primäroszillator (1) und der Rückkopplungsschleife eingesetzt ist, um die Frequenzreferenz mit einem Verhältnis N zu multiplizieren, und einen Teiler (9), der am Ausgang des Systems angeordnet ist, um den Ausgang (JFPO), der am Hilfsoszillator abgenommen wird, durch ein gleiches Verhältnis N zu teilen.


**Claims**

1. System for providing a frequency reference, comprising a primary oscillator (1) providing a frequency reference, and comprising:

- two feedback loops (20, 30) each comprising a phase comparator (21, 31) and an auxiliary oscillator (23, 33), the frequency reference being delivered to each feedback loop in order to control the auxiliary oscillator of each of the loops according to the frequency reference of the primary oscillator;
- a unit for detecting frequency micro-hops (3) of the frequency reference provided by the quartz primary oscillator, arranged to receive the phase-error voltage at the output of each of the phase comparators (21, 31) and configured to indicate an occurrence of a frequency micro-hop,
**characterised in that** the unit for detecting a frequency hop (3) is configured to
- compare the phase-error voltage at the output of each of the phase comparators with a threshold, and indicate an occurrence of a frequency hop in the case of simultaneous appearance of the threshold being exceeded on the two loops, or
- correlating the phase errors at the output of each of the phase comparators, and compare said correlation to a threshold, and **in that** the primary oscillator is a quartz oscillator.

2. System according to claim 1, further comprising a multiplier (8) interposed between the primary oscillator (1) and the feedback loop in order to multiply the frequency reference by a ratio N, and a divider (9) arranged at the output of the system in order to divide, by the same ratio N, the output (JFPO) taken from the auxiliary oscillator.

FIG. 1

PO

Is

JFPO

2

11

12

13

1

Seuil +

Seuil -

1.5

1

0.5

0

-0.5

-1

-1.5

0    0.2    0.4    0.6    0.8    1

Temps

FIG. 2

FIG. 3

FIG. 4c

FIG. 4b

FIG. 4a

FIG. 5

FIG. 6

FIG. 7

FIG. 8

FIG. 9

FIG. 10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4625180 A
- FR 2814870 A1
- US 2005157829 A1